# EUROPEAN PATENT APPLICATION

(11) **EP 4 841 865 A1**
(43) Date of publication of application: **18.11.2026**
(21) Application number: 26736574.0
(22) Date of filing: 27.03.2026
(51) Int. Cl.: H02K 1/12, H05K 1/16, H05K 1/02, H02K 3/50

(54) **STATOR STRUCTURE AND ALTERNATING CURRENT MOTOR**

(30) Priority: 27.03.2025 CN 202510370423
(71) Applicant: Zhejiang Sanhua Precision Drive Future Technology Co., Ltd., Hangzhou, Zhejiang 310018 (CN)
(72) Inventor: BI, Chao, Hangzhou, Zhejiang 310018 (CN); MA, Xiaojun, Hangzhou, Zhejiang 310018 (CN); BI, Lei, Hangzhou, Zhejiang 310018 (CN)
(74) Representative: Ström & Gulliksson AB
(86) International application number: PCT/CN2026/086522
(87) International publication number: WO 2026/201135

(57) **Abstract**

A stator structure and an alternating current motor are provided, relating to the technical field of alternating current motors. The stator structure includes a stator yoke and a flexible circuit board. A cavity is formed inside the stator yoke and runs through both ends thereof. The flexible circuit board is rolled and arranged flush against a cavity wall of the cavity. An end of the flexible circuit board is provided with a connection terminal for connecting to an external alternating current power supply. The flexible circuit board includes at least two conductive layers, with multiple wires arranged in each conductive layer. The wires in one conductive layer are electrically connected to those in another conductive layer to form multiple coils, which are spaced apart along a circumferential direction of the stator yoke and electrically connected to the connection terminal. The flexible circuit board is flush against an inner wall of the stator yoke. Current flows through the coils, generating a radial magnetic field perpendicular to the stator yoke, and this magnetic field form a magnetic circuit through the stator yoke. The stator winding of the present application enables the mounting of the stator structure by flush arrangements, enhancing the convenience of processing and assembling of the stator structure of the motor.

## Description

The present application claims priority to Chinese Patent Application No. 2025103704230, titled "STATOR STRUCTURE AND ALTERNATING CURRENT MOTOR", filed with the China National Intellectual Property Administration on March 27, 2025, which is incorporated herein by reference in its entirety.

### FIELD

The present application relates to the technical field of motors, and in particular to a stator structure and an alternating current motor.

### BACKGROUND

High-performance motors are applied in scenarios such as robots and medical devices, where stringent requirements are imposed on motor size and performance. For instance, three-phase alternating current motors, particularly permanent magnet alternating current motors, owing to their characteristics of high torque density, high efficiency, and excellent reliability, have emerged as a crucial technological pathway for achieving high performance and miniaturization. In these motors, an alternating current in the stator winding generate a rotating magnetic field, which interacts with the magnetic field produced by permanent magnet material on the rotor, thereby generating electromagnetic torque.

However, in a three-phase permanent magnet alternating current motor, the stator structure includes a stator core and stator armature windings. Although this design enables efficient electromagnetic conversion, the overall structure is relatively complex. In the application of such a complex stator structure in small motors, the processing and assembly of the stator structure are challenging, making it difficult to achieve large-scale mass production.

### SUMMARY

A main object of the present application is to provide a stator structure and an alternating current motor, so as to address the challenges in processing and assembly of existing stator structures.

To achieve this object, the stator structure provided according to the present application includes a stator yoke and a flexible circuit board. A cavity is formed inside the stator yoke and runs through both ends of the stator yoke. The flexible circuit board is rolled and arranged flush against a cavity wall of the cavity. An end of the flexible circuit board is provided with a connection terminal for connecting to an external alternating-current power source. The flexible circuit board includes at least two conductive layers, with multiple wires provided in each conductive layer. The wires in one conductive layer are electrically connected to the wires in another conductive layer to form multiple coils, which are arranged along a circumferential direction of the stator yoke and spaced apart from each other. The coils are connected in series to form a winding of each phase, and are all electrically connected to the connection terminal.

The flexible circuit board is arranged flush against an inner wall of the stator yoke. When a current passes through the coils, a radial magnetic field perpendicular to the stator yoke is generated in a motor air gap, and the magnetic field forms a magnetic circuit with the help of the stator yoke.

In an embodiment of the present application, multiple coils are connected in series to form a full-pitch distributed lap winding.

The flexible circuit board includes a first conductive layer and a second conductive layer. Multiple conductive through-holes are formed in each of the first conductive layer and the second conductive layer and located close to edges thereof. One wire in the first conductive layer is electrically connected to one wire in the second conductive layer through one conductive through-hole located close to one edge of the flexible circuit board, the one wire in the second conductive layer is electrically connected to another wire in the first conductive layer through another conductive through-hole located close to another edge of the flexible circuit board, and the another wire in the first conductive layer is electrically connected to another wire in the second conductive layer through yet another conductive through-hole located close to the one edge of the flexible circuit board, ultimately forming a complete full-pitch distributed lap winding.

The multiple wires in the first conductive layer are connected to the multiple wires in the second conductive layer in an alternating sequence, forming the full-pitch distributed lap winding of each phase.

In an embodiment of the present application, each wire includes at least a first segment, a second segment, and a third segment connected in the listed sequence. The second segment is parallel to an axial direction of the stator yoke. The first segment and the third segment are inclined relative to the second segment toward the same direction. The multiple wires in each conductive layer are sequentially arranged along the circumferential direction of the stator yoke and spaced apart from each other.

In an embodiment of the present application, a projection of at least one first segment in the first conductive layer in a direction perpendicular to a surface of the flexible circuit board intersects with a projection of at least one first segment in the second conductive layer in the same direction. Similarly, a projection of at least one third segment in the first conductive layer in the second conductive layer in the direction perpendicular to the surface of the flexible circuit board intersects with a projection of at least one third segment in the second conductive layer in the same direction.

In an embodiment of the present application, projections of multiple second segments in the first conductive layer and projections of multiple second segments in the second conductive layer in the direction perpendicular to the surface of the flexible circuit board are evenly spaced. Two ends of the flexible circuit board abut against each other, and the flexible circuit board is rolled and arranged flush against an inner wall of the stator yoke.

In an embodiment of the present application, part of projections of multiple second segments in the first conductive layer in the direction perpendicular to the surface of the flexible circuit board overlap with part of projections of multiple second segments in the second conductive layer in the same direction, or are spaced apart from part of projections of multiple second segments in the second conductive layer in the same direction by a small line spacing. Two ends of the flexible circuit board partially overlap with each other, and the flexible circuit board is rolled and arranged flush against an inner wall of the stator yoke.

In an embodiment of the present application, a line width of the second segment is greater than a line width of the first segment and a line width of the third segment.

In an embodiment of the present application, the flexible circuit board is polygonal in shape, and the wires are parallel to sides of the flexible circuit board adjacent to the wires.

Alternatively, the flexible circuit board is rectangular in shape, and the wires form right angles close to corners of the flexible circuit board.

In an embodiment of the present application, the conductive layers are provided with a neutral-point connection hole. Multiple wires in the conductive layers are wound to form full-pitch distributed lap windings of three phases. The full-pitch distributed lap windings of the three phases are all electrically connected to the neutral-point connection hole, and the full-pitch distributed lap windings of the three phases are arranged in a Y-connection configuration.

An alternating current motor is further provided according to the present application, which includes a rotor and the stator structure described in any one of the above solutions. The rotor is rotatably disposed within the cavity, and the flexible circuit board is arranged around an outer periphery of the rotor.

The stator structure according to the present application includes a stator yoke and a flexible circuit board. A cylindrical cavity is formed inside the stator yoke, and the flexible circuit board, including at least two conductive layers, is rolled into a cylindrical or tubular shape and arranged flush against the inner wall of the stator yoke. The flexible circuit board includes at least two conductive layers, with multiple wires provided in each conductive layer. The wire in one conductive layer is electrically connected to the wire in another conductive layer to form a coil. There are multiple coils, which are spaced apart along the circumferential direction of the stator yoke. An end of the flexible circuit board is provided with a connection terminal, through which the coils are electrically connected to an external alternating current power source. Due to the spaced arrangement of the multiple coils along the circumferential direction of the stator yoke after the flexible circuit board is rolled, a varying current generates a magnetic field, resulting in a radial magnetic field in the motor air gap to drive the rotor to rotate.

According to the present application, a solution in which coils are arranged on the flexible circuit board and flush against the inner wall of the stator yoke is provided. Compared with a solution in which coils are arranged in stator slots of a stator core, the solution provided in this application reduces the structural volume occupied by the stator structure. Moreover, it eliminates the need for stator slots on the stator yoke, allowing easy mounting of the stator structure through flush attachment and enhancing the convenience of processing and assembling the stator structure of the motor. Furthermore, since the wires in the two conductive layers are connected in a looped manner to form the coils, that is, the wound wires of each coil are distributed in two conductive layers. Compared with the solution in which all the wound wires of a coil are arranged in the same conductive layer, the solution provided in this application reduces the difficulty of coil fabrication, eliminating the need for complex winding equipment and manufacturing processes, and improving the manufacturing precision of the stator structure.

### BRIEF DESCRIPTION OF THE DRAWINGS

For more clearly illustrating embodiments of the present application or technical solutions in the related art, the drawings referred to for describing the embodiments or the related art will be briefly described hereinafter. Apparently, the drawings in the following description only show some embodiments of the present application, and for those skilled in the art, other drawings may be obtained based on these drawings without any creative efforts.
FIG. 1 is a schematic structural view of an alternating current motor according to an embodiment of the present application;
FIG. 2 is a cross-sectional view taken along line A-A in FIG. 1;
FIG. 3 is a schematic structural view of an alternating current motor according to another embodiment of the present application;
FIG. 4 is a schematic structural view of a flexible circuit board of a stator structure according to an embodiment of the present application;
FIG. 5 is a schematic developed view of the flexible circuit board in FIG. 4;
FIG. 6 is a schematic developed view showing the structure of two conductive layers of the flexible circuit board in FIG. 5;
FIG. 7 is a schematic structural view of a first winding of the flexible circuit board in FIG. 5;
FIG. 8 is a schematic structural view of a second winding of the flexible circuit board in FIG. 5;
FIG. 9 is a schematic structural view of a third winding of the flexible circuit board in FIG. 5;
FIG. 10 is a schematic structural view of a flexible circuit board of a stator structure according to another embodiment of the present application;
FIG. 11 is a schematic developed view of the flexible circuit board in FIG. 10;
FIG. 12 is a schematic developed view showing the structure of two conductive layers of the flexible circuit board in FIG. 11;
FIG. 13 is a schematic structural view of a first winding of the flexible circuit board in FIG. 11;
FIG. 14 is a schematic structural view of a second winding of the flexible circuit board in FIG. 11;
FIG. 15 is a schematic structural view of a third winding of the flexible circuit board in FIG. 11;
FIG. 16 is a partially enlarged schematic view of one of the windings of the flexible circuit board in FIG. 11;
FIG. 17 is a schematic developed view showing the structure of a flexible circuit board of a stator structure according to yet another embodiment of the present application; and

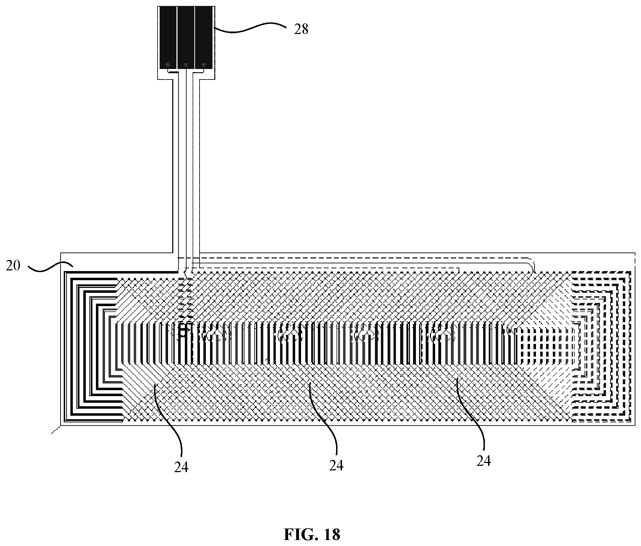

FIG. 18 is a schematic developed view showing the structure of a flexible circuit board of a stator structure according to still another embodiment of the present application.

Reference numerals in the figures are as follows:

| | | | |
|---|---|---|---|
| 1 | stator structure; | 10 | stator yoke; |
| 11 | cavity; | 20 | flexible circuit board; |
| 21 | first conductive layer; | 22 | second conductive layer; |
| 23 | wire; | 231 | first segment; |
| 232 | second segment; | 233 | third segment; |
| 24 | coil; | 25 | conductive through-hole; |
| 26 | full-pitch distributed lap winding; | 27 | neutral-point connection hole; |
| 28 | connection terminal; | 281 | power supply pad; |
| 30 | rotor; | 40 | magnetic field detection assembly; |
| 41 | circuit control board; | 42 | Hall sensor. |

The implementation of the objects, functional features and advantages of the present application will be further explained with reference to the accompanying drawings in combination with the embodiments.

### DETAILED DESCRIPTION OF THE EMBODIMENTS

Technical solutions of embodiments of the present application will be clearly and completely described hereinafter with reference to the drawings of the embodiments of the present application. Apparently, the embodiments described are only part of the embodiments of the present application, rather than all the embodiments. Based on the embodiments of the present application, all other embodiments obtained by those skilled in the art without creative efforts shall fall within the protection scope of the present application.

It should be noted that, if there are directional indicators (such as up, down, left, right, front, back, etc.) in the embodiments of the present application, the directional indicators are only used for explaining a relative position relationship, movement situation and the like among components in a specific orientation. If the specific orientation changes, the directional indicators change accordingly.

In addition, if there is description related to terms "first", "second", and the like in the embodiments of the present application, the terms "first", "second", and the like are only for description purposes, and should not be understood as indicating or implying their relative importance or implicitly indicating the number of technical features indicated. Therefore, a feature defined by "first" and "second" may explicitly or implicitly include at least one such feature. In addition, the meaning of "and/or" appearing herein includes three parallel solutions. Taking "A and/or B" as an example, it includes A solution, B solution, or a solution that both A and B satisfy. In addition, the technical solutions of the various embodiments can be combined with each other, provided that such combination can be implemented by those skilled in the art. If a combination of the technical solutions is self-contradictory or cannot be implemented, it should be considered that such combination of the technical solutions neither exist nor fall within the protection scope of the present application.

A stator structure 1 is provided according to the present application.

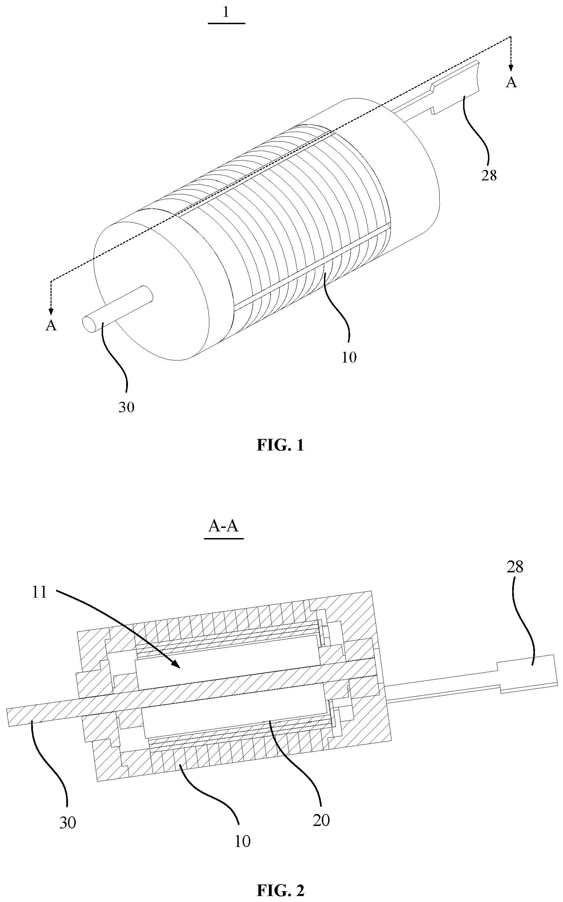

As shown in FIGS. 1 to 5, in an embodiment of the present application, the stator structure 1 includes a stator yoke 10 and a flexible circuit board 20. A cavity 11 is formed inside the stator yoke 10 and runs through both ends of the stator yoke 10. The flexible circuit board 20 is rolled and arranged flush against a cavity wall of the cavity 11. An end of the flexible circuit board 20 is provided with a connection terminal 28 for connecting to an external alternating current power supply. The flexible circuit board 20 includes at least two conductive layers. Multiple wires 23 are provided in each conductive layer. The wires 23 in one conductive layer are electrically connected to the wires 23 in another conductive layer to form multiple coils 24. The multiple coils 24 are arranged along a circumferential direction of the stator yoke 10, spaced apart from each other, and electrically connected to the connection terminal 28.

The flexible circuit board 20 is arranged flush against an inner wall of the stator yoke 10. When a current passes through the coils 24, a radial magnetic field perpendicular to the stator yoke 10 is generated in a motor air gap, and this magnetic field forms a magnetic circuit with the help of the stator yoke 10.

In this embodiment, the stator structure 1 includes a cylindrical stator yoke 10, with a cavity 11 formed inside the stator yoke and runs through both ends of the stator yoke. The stator yoke 10 is made of a soft magnetic material with high magnetic permeability. This material can significantly enhance the magnetic field strength and efficiency of the motor. The stator yoke 10 may be manufactured through various processes, such as adhesive bonding, welding, or a combination of adhesive bonding and welding, where multiple pieces of soft magnetic material are fixed together, forming a robust integral structure. Additionally, the stator yoke 10 may be designed in different geometric shapes, such as cylindrical or polygonal prismatic, based on actual requirements, to adapt to different motor application scenarios.

The flexible circuit board 20 is one of the core components of the present application and is manufactured through the FPCB (Flexible Printed Circuit Board) technology. The flexible circuit board 20 includes at least two conductive layers. Multiple wires 23 are provided in each conductive layer. These wires 23 are manufactured with high precision and consistency through precise processes such as lamination, photolithography, and etching. To prevent short circuit between the at least two conductive layers, each conductive layer is provided with two insulating layers, with the multiple wires 23 sandwiched between the two conductive layers. The insulating layers are made of material with high-temperature resistance and excellent electrical insulating properties, such as polyimide.

An end of the flexible circuit board 20 is provided with a connection terminal 28 for connecting to an external alternating current power supply. The stability and reliability of current transmission are critical considerations in the design of the connection terminal 28, and thus the connection terminal 28 is generally made of metal materials with good electrical conductivity, such as copper. The connection terminal 28 may be connected to the external power supply through methods such as soldering or crimping, ensuring efficient transmission of current to each coil 24 on the flexible circuit board 20.

The wires 23 in the two conductive layers are alternately connected to form the coils 24. This design not only simplifies the manufacturing process of the coils 24 but also improves their precision and stability. Compared with a solution where all wires 23 of the coils 24 are arranged in the same conductive layer, the coils 24 in the present application are formed by connecting the wires 23 in the two conductive layers through conductive through-holes 25 located close to edges of the flexible circuit board 20. That is, the wound wires 23 of the coils 24 are respectively arranged in the two conductive layers. This approach reduces the manufacturing difficulty of the coils 24, eliminating the need for complex winding equipment and manufacturing processes, thereby improving the manufacturing precision of the stator structure 1. The number and layout of the coils 24 may be adjusted based on the specific requirements for the motor. The multiple coils 24 are evenly spaced along the circumferential direction of the stator yoke 10 to ensure uniform distribution of the generated magnetic field. Additionally, a winding direction of the coils 24 may be designed based on actual application requirements, and may be either clockwise or counterclockwise, so as to meet different requirements for magnetic field direction.

When a current passes through the coils 24, a radial magnetic field perpendicular to the stator yoke 10 is generated in the motor air gap. This magnetic field forms a closed magnetic circuit through the stator yoke 10, thus driving a rotor 30 to rotate. To further optimize the magnetic field distribution, the multiple coils 24 are evenly spaced along the circumferential direction of the stator yoke 10. This layout not only improves the uniformity of the magnetic field but also reduces vibration and noise during motor operation.

The flexible circuit board 20 may be directly arranged flush against the inner wall of the stator yoke 10, simplifying the mounting process. Compared with the traditional solution where the coils 24 are disposed in stator slots of the stator core, the design according to the present application significantly reduces the structural volume occupied by the stator winding and improves the convenience of processing and assembly.

In some embodiments, the flexible circuit board 20 may further integrate a magnetic field detection assembly 40, such as a Hall sensor 42 and a circuit control board 41. The Hall sensor 42 is configured to detect a magnetic field of the rotor 30 during motor operation, thereby detecting an angle of the rotor 30. The circuit control board 41 is configured to process data collected by the Hall sensor 42 and feed it back to a control system to achieve precise motor control. This design not only improves the control precision of the motor but also enhances the reliability and stability of the system.

According to this application, the conventional solution based on a stator core and stator slots is replaced by the flexible circuit board 20, greatly simplifying the mounting process of the stator winding and significantly reducing the structural volume occupied by the stator winding. The flexible circuit board 20 manufactured through high-precision FPCB technology makes the manufacturing of the coils 24 simpler and more precise. Additionally, the arrangement of the coils 24 in multiple conductive layers not only improves the uniformity of the magnetic field and the operating efficiency of the motor but also reduces resistive loss, thereby enhancing the overall performance of the motor.

A series of improvements and researches were made on slotless stator windings. In some embodiments, all wires 23 of the same coil 24 may be arranged in the same conductive layer, which can also achieve the effect of reducing the structural volume of the stator winding. However, to achieve a uniform rotating magnetic field, it imposes requirements for the shape and the winding direction of the coils 24, and the line spacing between the wires. To arrange the coils 24 in the same conductive layer, connection holes need to be provided inside a winding to connect it to other windings, making the processing of the winding difficult and the precision hard to control. Moreover, the concentric coils formed in the same conductive layer have poor electromagnetic characteristics due to their low ability to generate back electromotive force, which leads to low motor constant. In the present application, the full-pitch distributed coils have improved ability to generate back electromotive force, enhancing the efficiency and torque density of the motor.

In this embodiment, in particular, each coil 24 is formed by the wires 23 in the two conductive layers connected in an enclosing manner, which reduces the manufacturing difficulty of the coils 24, eliminating the need for complex winding equipment and manufacturing processes, thereby improving the manufacturing precision of the stator structure 1. This design is not only suitable for small motors but also for high-performance motor application scenarios with high space utilization requirements.

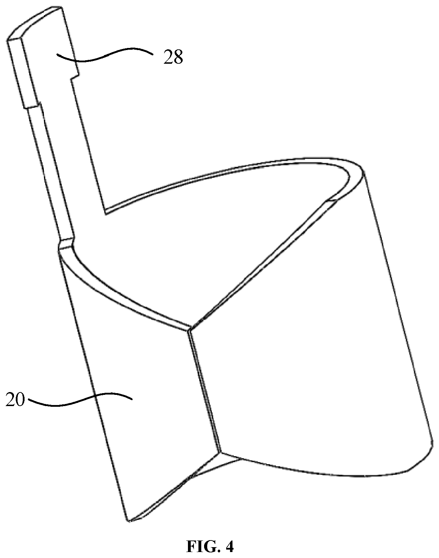

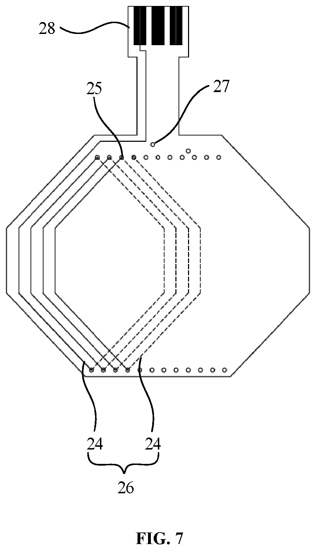

As shown in FIGS. 4 to 8, in an embodiment of the present application, multiple coils 24 are connected in series to form a full-pitch distributed lap winding 26.

The flexible circuit board 20 includes a first conductive layer 21 and a second conductive layer 22. Each of the first conductive layer 21 and the second conductive layer 22 is provided with multiple conductive through-holes 25 located close to edges thereof. One wire 23 in the first conductive layer 21 is electrically connected to one wire 23 in the second conductive layer 22 through a conductive through-hole 25 located close to one edge of the flexible circuit board 20. The one wire 23 in the second conductive layer 22 is electrically connected to another wire 23 in the first conductive layer 21 through a conductive through-hole 25 located close to another edge of the flexible circuit board 20. The another wire 23 in the first conductive layer 21 is electrically connected to another wire 23 in the second conductive layer 22 through a conductive through-hole 25 located close to the one edge of the flexible circuit board 20.

The multiple wires 23 in the first conductive layer 21 and the multiple wires 23 in the second conductive layer 22 are connected in an alternating sequence, forming the full-pitch distributed lap winding 26 of each phase.

In this embodiment, the full-pitch distributed lap winding 26 can generate a back electromotive force that is nearly sinusoidal, which makes the electromagnetic performance of the motor more stable during operation, reduces the influence of higher-order harmonics, and thus decreases motor losses and noise. Due to its distributed nature, it can effectively weaken harmonic magnetomotive forces and improve the starting performance of the motor. Additionally, since the wires 23 of the coils 24 are arranged in two stacked conductive layers and are connected in series through the conductive through-holes 25 located close to the edges of the flexible circuit board 20 to form the winding, the formation of this full-pitch distributed lap winding 26 does not require folding of the flexible circuit board 20, facilitating processing and mounting compared with concentrated windings,.

The full-pitch distributed lap winding 26 of each phase is composed of multiple wires 23 respectively distributed in the first conductive layer 21 and the second conductive layer 22 of the flexible circuit board 20 and connected through the conductive through-holes 25 located close to the edges of the flexible circuit board 20. The multiple wires 23 in one conductive layer are separated from the multiple wires 23 in another conductive layer by an insulating layer to prevent short circuit. The wires 23 are made of highly conductive materials (such as copper or silver) to ensure efficient current transmission.

The multiple wires 23 in the first conductive layer 21 have equal line spacing and identical shapes, and the multiple wires 23 in the second conductive layer 22 also have equal line spacing and identical shapes. Therefore, only through the above connection method can a full-pitch distributed lap winding be formed. Compared with the solution in which the wires are continuously wound in the same conductive layer to form the coils 24, this embodiment improves the convenience of processing the full-pitch distributed lap winding, enhances the wiring convenience of the wires 23 of the coils 24, and increases the uniformity of the magnetic field generated by the formed full-pitch distributed lap winding in the circumferential direction in which the magnetic field rotates and in the axial direction, enabling the generation of back electromotive force with a high motor constant. The above solutions and effects cannot be achieved by the solution in which the coil 24 is formed in the same conductive layer.

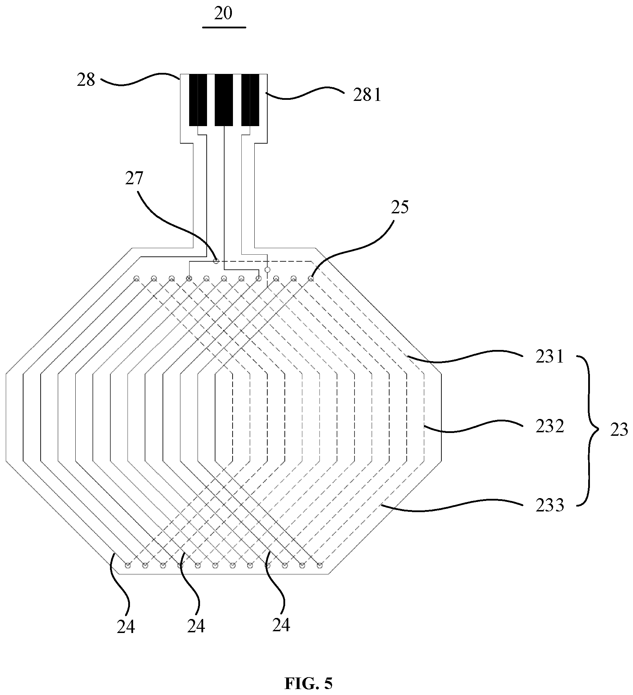

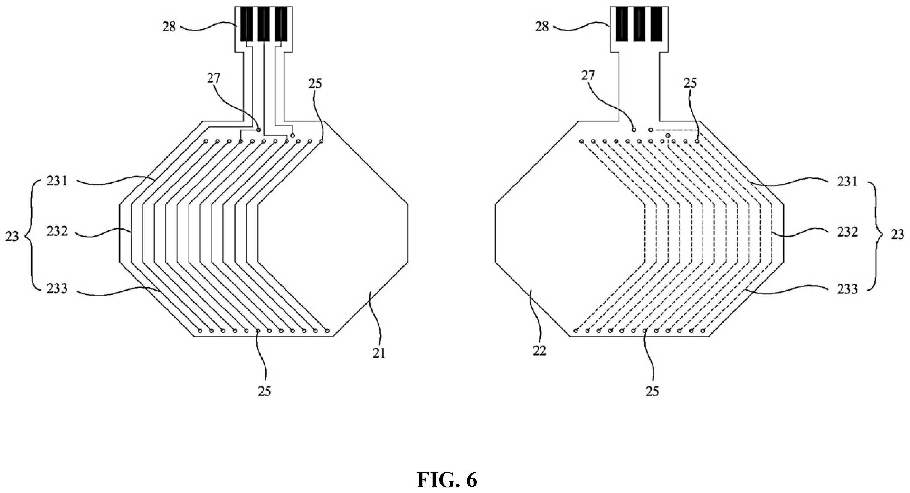

To achieve electrical connections between the wires 23 in the two conductive layers, conductive through-holes 25 may be provided in the conductive layers. The multiple conductive through-holes 25 in each conductive layer coincide with the multiple conductive through-holes 25 of other conductive layer in a thickness direction of the flexible circuit board 20 when it is unfolded and laid flat (referring to FIGS. 5 and 6, in a direction of the flexible circuit board 20 perpendicular to the paper sheets). Each conductive through-hole 25 is copper-plated to ensure good electrical conductivity. One wire 23 in the first conductive layer 21 is electrically connected to one wire 23 in the second conductive layer 22 through a conductive through-hole 25, another wire 23 in the second conductive layer 22 is electrically connected to another wire 23 in the first conductive layer 21, and so on, until a complete full-pitch distributed lap winding 26 is formed.

The winding direction of the coils 24 can be designed based on actual application requirements, which may be either clockwise or counterclockwise, to meet different requirements for the magnetic field direction. While the multiple wires 23 of the full-pitch distributed lap winding 26 are sequentially connected between the two conductive layers, the multiple sets of coils 24 as a whole extend along the circumferential direction of the stator yoke 10, and the multiple coils 24 also extend along the circumferential direction of the stator yoke 10 to ensure uniform magnetic field distribution.

In this embodiment, the wires 23 in the two conductive layers are alternately connected through the conductive through-holes 25 located close to the edges of the flexible circuit board 20 to form the coils 24. Compared with a solution in which all the wires 23 are concentrated in the same conductive layer, this method reduces the fabrication difficulty of the coils 24, eliminates the need for complex winding equipment and manufacturing processes, and thus improves the manufacturing precision of the stator structure 1. Moreover, the arrangement and winding of the wires 23 of the coils 24 are more uniform, resulting in a more uniform magnetic field distribution.

In addition, the wires 23 may have different shape designs, such as straight, polygonal, or curved, to adapt to different application scenarios. In some high-power motors, each wire 23 may have a thick cross-section to reduce resistive losses and improve the overall efficiency of the motor.

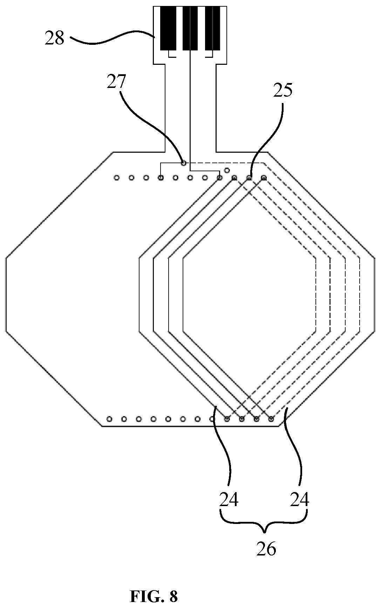

As shown in FIGS. 4 and 8, in an embodiment of the present application, each wire 23 includes at least a first segment 231, a second segment 232, and a third segment 233 connected in the listed sequence. The second segment 232 is parallel to an axial direction of the stator yoke 10. The first segment 231 and the third segment 233 are inclined in different directions relative to the second segment 232. The multiple wires 23 in each conductive layer are arranged along the circumferential direction of the stator yoke 10 and are spaced apart from each other.

In this embodiment, the wire 23 adopts a multi-segment design. The second segment 232 is parallel to the axial direction of the stator yoke 10, while the first segment 231 and the third segment 233 are inclined. This design makes the magnetic field of the full-pitch distributed lap winding 26 formed by the combination of multiple wires 23 more uniform. The wire 23 in each conductive layer is formed by connecting the first segment 231, the second segment 232, and the third segment 233. In the same coil 24, inclination angles of the first segment 231 and the third segment 233 relative to the second segment 232 may be equal to facilitate winding and fabrication of the wire 23.

As shown in FIGS. 5 and 6, the multiple wires 23 in each conductive layer are arranged along the circumferential direction of the stator yoke 10 and are spaced apart from each other. The wires 23 in each conductive layer are designed to have the same structure and be evenly spaced. The wires in the two conductive layers are symmetrically arranged, so that when a wire 23 in one conductive layer is connected to another wire 23 in the other conductive layer, a coil 24 structure with a shape similar to a rhombus is formed. When the coil 24 is energized, the varying current generates a magnetic field in a radial direction of the stator yoke 10.

The inclination angles of the first segment 231 and the third segment 233 of the wire 23 relative to the second segment 232 may be adjusted based on actual requirements to optimize the magnetic field distribution and reduce heat accumulation in areas with concentrated current density. For example, in high-power motors, an appropriate inclination angle can improve heat dissipation performance and reduce vibration and noise during motor operation.

It can be understood that since the wires of the coils in this application are respectively arranged in the first conductive layer and the second conductive layer, it is convenient to change the wire shapes and angles in the first conductive layer and the second conductive layer based on requirements, thereby forming coils of different shapes and sizes. Compared with the solution in which the coil is formed in the same conductive layer, the designed solution according to this application can significantly improve the ability of the motor coils to generate back electromotive force and enhance the electromagnetic characteristics of the winding. Furthermore, winding and fabrication of the wires are relatively easy to achieve.

As shown in FIGS. 6 to 8, in an embodiment of the present application, a projection of at least one first segment 231 in the first conductive layer 21 in a direction perpendicular to a surface of the flexible circuit board 20 intersects a projection of at least one first segment 231 in the second conductive layer 22 in the same direction. A projection of at least one third segment 233 in the first conductive layer 21 in the direction perpendicular to the surface of the flexible circuit board 20 intersects a projection of at least one third segment 233 in the second conductive layer 22 in the same direction.

In this embodiment, since an insulating layer is provided between the wires 23 in the two conductive layers, although the projections of the at least one third segment 233 in the first conductive layer 21 and the at least one third segment 233 in the second conductive layer 22 in the direction perpendicular to the surface of the flexible circuit board 20 intersects each other, it does not cause short circuit between the wires 23. In addition, the coil 24 formed based on this structural design is shown in FIGS. 6 to 8. The coil 24 extends along the circumferential direction of the stator yoke 10 while being wound either clockwise or counterclockwise. Therefore, when the flexible circuit board 20 is rolled and arranged flush against the inner wall of the stator yoke 10, the generated magnetic field is more uniformly distributed along the circumferential direction of the stator yoke 10. In other embodiments, the full-pitch distributed lap winding 26 may be formed by multiple wires 23 connected together and wound around the same center.

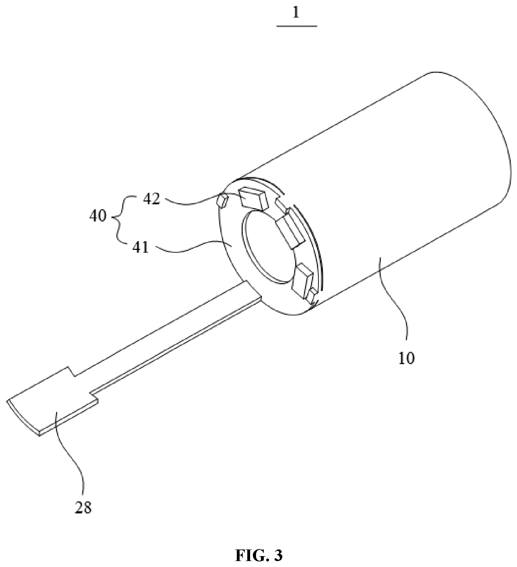

As shown in FIGS. 3 to 8, in an embodiment of the present application, projections of multiple second segments 232 in the first conductive layer 21 and multiple second segments 232 in the second conductive layer 22 in a direction perpendicular to a surface of the flexible circuit board 20 are evenly spaced. Two ends of the flexible circuit board 20 abut against each other, and the flexible circuit board 20 is rolled and arranged flush against the inner wall of the stator yoke 10.

In this embodiment, the projections of multiple second segments 232 in the first conductive layer 21 in the direction perpendicular to the surface of the flexible circuit board 20 and the projections of multiple second segments 232 in the second conductive layer 22 in the same direction are evenly spaced. This evenly spaced arrangement ensures a uniform distribution of current between the two conductive layers, enhancing the uniformity and strength of the magnetic field, and reducing vibration and noise issues. Furthermore, this evenly spaced arrangement of the second segments 232 results in a uniform distribution of the magnetic field in the circumferential direction of the stator yoke 10. Since the two ends of the flexible circuit board 20 abut against each other and the flexible circuit board 20 is rolled and arranged flush against the inner wall of the stator yoke 10, the second segments 232 of the flexible circuit board 20 are evenly spaced along the circumferential direction of the stator yoke 10, thereby improving the uniformity of the magnetic field distribution.

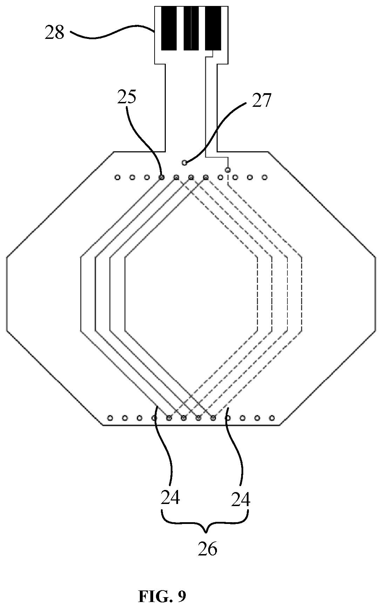

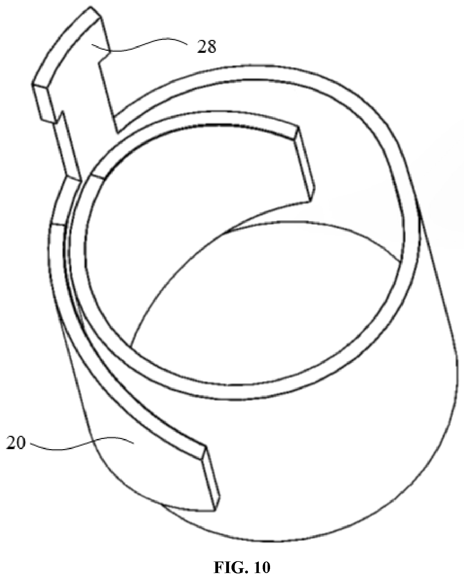

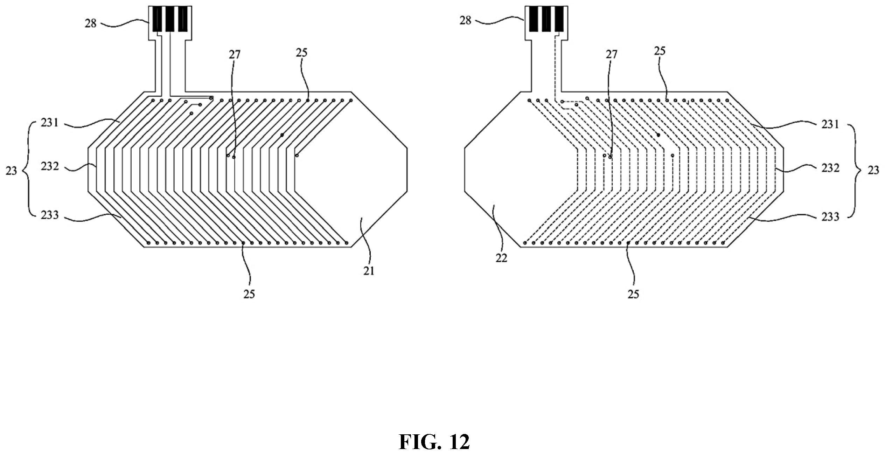

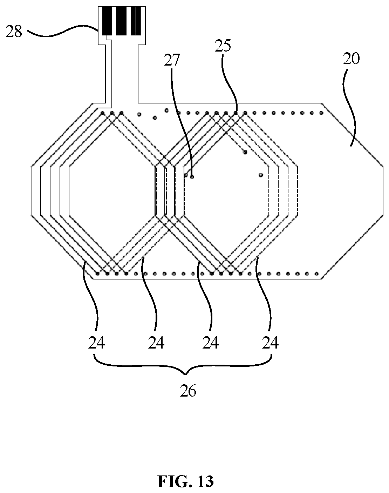

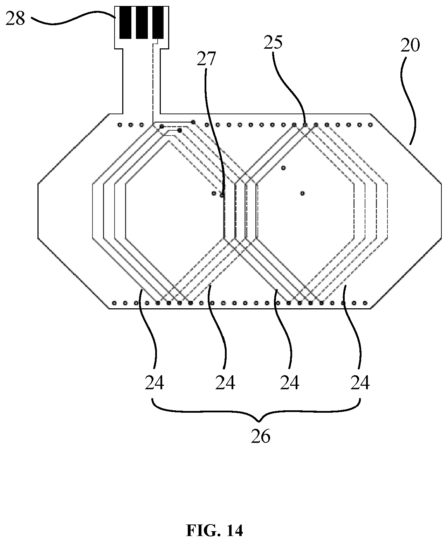

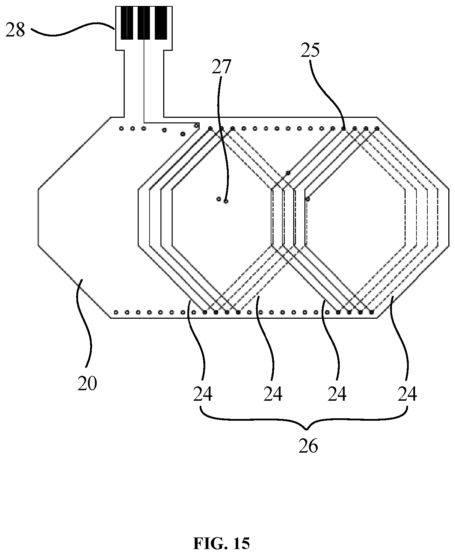

As shown in FIGS. 9 to 15, in an embodiment of the present application, part of projections of multiple second segments 232 in the first conductive layer 21 in a direction perpendicular to the surface of the flexible circuit board 20 overlap with part of projections of multiple second segments 232 in the second conductive layer 22 in the same direction partially, or are spaced apart from part of projections of multiple second segments 232 in the second conductive layer 22 in the same direction by a small line spacing. Two ends of the flexible circuit board 20 partially overlap with each other, and the flexible circuit board 20 is rolled and arranged flush against the inner wall of the stator yoke 10.

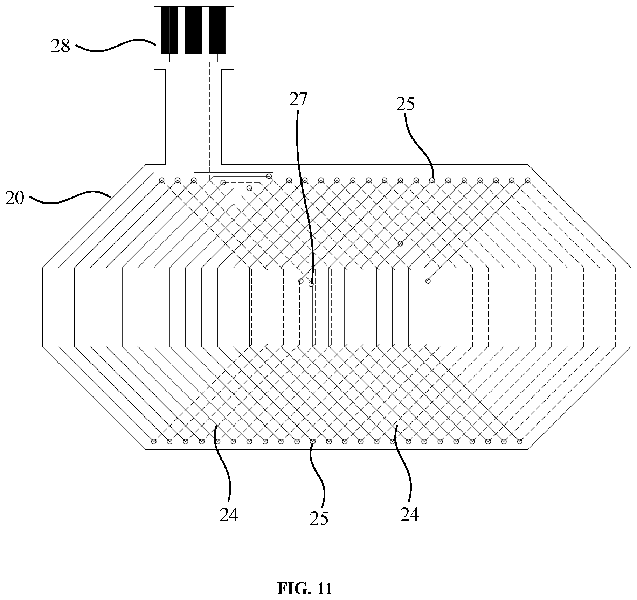

In this embodiment, as shown in FIGS. 6 and 11, a region occupied by multiple second segments 232 in the second conductive layer 22 partially overlaps with a region occupied by multiple second segments 232 in the first conductive layer 21. In the overlapping region, projections of multiple of the second segments 232 in the first conductive layer 21 in the direction perpendicular to the surface of the flexible circuit board 20 may overlap with projections of multiple of the second segments 232 in the second conductive layer 22 in the same direction, or may be spaced apart from the projections of multiple of the second segments 232 in the second conductive layer 22 in the same direction. It can be understood that in the overlapping region, the line spacing between the second segment 232 in the first conductive layer 21 and the adjacent second segment 232 in the second conductive layer 22 is small, resulting in a higher magnetic field strength in this region. This design increases the current density and enhances the local magnetic field strength.

Further, the two ends of the flexible circuit board 20 (referring to FIG. 11, where one end of the flexible circuit board 20 refers to a part to the left of a line connecting centers of an upper leftmost conductive through-hole and a lower leftmost conductive through-hole of the flexible circuit board 20, and the other end of the flexible circuit board 20 refers to a part to the right of a line connecting centers of an upper rightmost conductive through-hole and a lower rightmost conductive through-hole of the flexible circuit board 20) at least partially overlap with each other, and the flexible circuit board 20 is rolled and arranged flush against the inner wall of the stator yoke 10. As shown in FIGS. 6 and 11, in the overlapping part of the two ends of the flexible circuit board 20, at least a part of multiple second segments 232 in the first conductive layer 21 overlap with or are staggered relative to at least a part of multiple second segments 232 in the second conductive layer 22 in the radial direction of the flexible circuit board 20 after it is rolled. Or, in the overlapping part of the two ends of the flexible circuit board 20, a part of multiple second segments 232 in the first conductive layer 21 overlap with a part of multiple second segments 232 in the second conductive layer 22, and another part of multiple second segments 232 in the first conductive layer 21 are arranged alternately with another part of multiple second segments 232 in the second conductive layer 22. Therefore, when the flexible circuit board 20 is rolled, since the two ends of the flexible circuit board 20 overlap with each other, this reduces the line spacing between the second segments 232 and/or increases the density of the second segments 232, which originally had a large line spacing and low density. Through the above structural design and winding method, the magnetic field formed by the flexible circuit board 20 is more uniformly distributed along the circumferential direction of the stator yoke 10 and has a higher magnetic field strength. This design is particularly suitable for applications with high requirements for magnetic field strength and motor efficiency, improving the strength and uniformity of the magnetic field and reducing vibration and noise during motor operation.

In an embodiment of the present application, a line width of the second segment 232 is greater than a line width of the first segment 231 and a line width of the third segment 233.

In this embodiment, the second segment 232 is parallel to the axial direction of the stator yoke 10, and its line width is greater than the line width of the first segment 231 and the line width of the third segment 233. This design reduces resistance losses, improves current transmission efficiency, and reduces the risk of local heating. The wider second segment 232 helps optimize the current path, allowing the current to be more uniformly distributed between the two conductive layers, enhancing the uniformity and strength of the magnetic field, and improving the heat dissipation performance of the motor. In addition, as shown in FIGS. 6 to 8, compared with the first segment 231 and the third segment 233, the line spacing between multiple second segments 232 is larger, facilitating the processing of wider second segments 232.

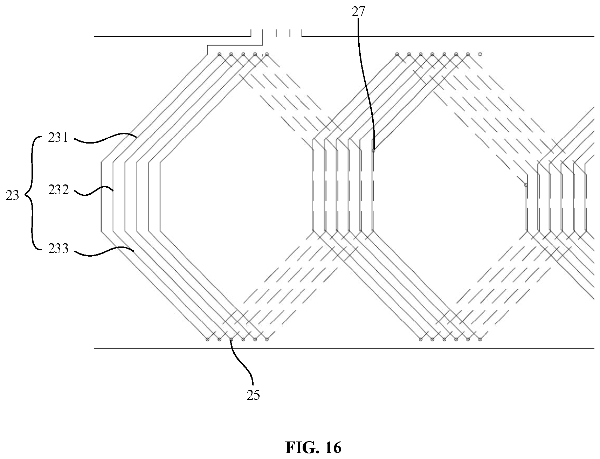

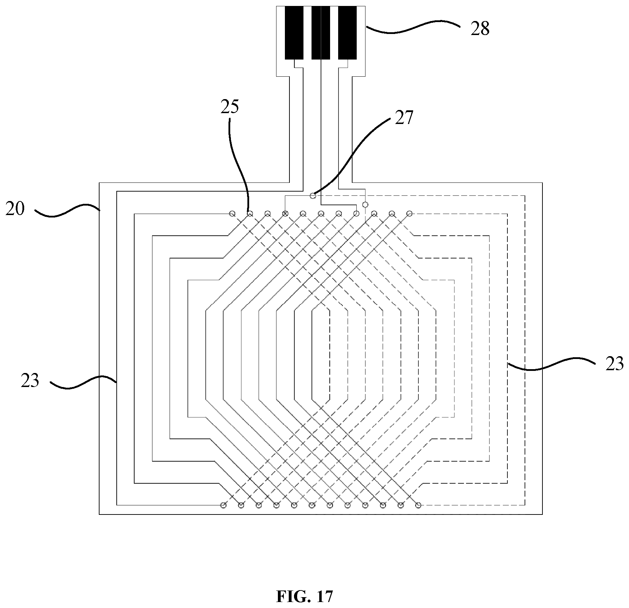

As shown in FIGS. 4 to 8 and FIGS. 10 to 15, in an embodiment of the present application, the flexible circuit board 20 is polygonal in shape, and the wires 23 are parallel to sides of the flexible circuit board 20 adjacent to the wires 23;
or, as shown in FIGS. 16 and 17, the flexible circuit board 20 is rectangular in shape, and the wires 23 form right angles close to corners of the flexible circuit board 20.

In this embodiment, the shape of the flexible circuit board 20 may be hexagonal, octagonal, or the like. In a case where the flexible circuit board 20 is polygonal in shape, the wires 23 are parallel to sides of the flexible circuit board 20 adjacent to the wires 23. This design allows the wires 23 to better conform to the inner wall of the stator yoke 10 when the flexible circuit board 20 is rolled and optimizes the magnetic field distribution. The polygonal design provides more flexibility and is suitable for stator yokes 10 of different shapes and sizes, improving the convenience of mounting and assembly.

In another embodiment, in a case where the flexible circuit board 20 is rectangular in shape, the wires 23 form right angles close to the corners, allowing the wires 23 located close to the edges of the flexible circuit board 20 to better conform to the shape of the flexible circuit board 20, thereby increasing the number and density of wires on the surface of the flexible circuit board 20. Meanwhile, when the flexible circuit board 20 is rolled and arranged on the inner wall of the stator yoke 10, the magnetic field generated by the flexible circuit board 20 can be more uniform in both the circumferential and axial directions of the stator yoke 10, making full use of the space of the rectangular flexible circuit board 20.

As shown in FIGS. 4 to 8 and FIGS. 10 to 17, in an embodiment of the present application, each conductive layer is provided with multiple conductive through-holes 25. At least two conductive layers are stacked together, and the multiple conductive through-holes 25 in one conductive layer respectively coincide with the multiple conductive through-holes 25 in each of the remaining conductive layer in a direction perpendicular to the conductive layers. The two wires 23 of each coil 24 are electrically connected through the conductive through-hole 25. Since these conductive through-holes 25 coincide with each other in the direction perpendicular to the conductive layers, electrical connections between different conductive layers can be achieved.

In this embodiment, multiple conductive through-holes 25 are provided in each conductive layer. The positions of the through-holes in the conductive layers are precisely aligned to ensure that the wires 23 in different conductive layers can be electrically connected through the through-holes. The conductive through-holes 25 are copper-plated to ensure good conductivity and mechanical strength.

At least two conductive layers are stacked together, and the multiple conductive through-holes 25 in each conductive layer respectively overlap with the multiple conductive through-holes 25 in the remaining conductive layer in the direction perpendicular to the conductive layers. This design allows the current to flow smoothly between different conductive layers, forming a complete current path. The two wires 23 of each coil that are located in different layers are electrically connected through the conductive through-hole 25.

In addition, as shown in FIGS. 4 to 8 and FIGS. 10 to 17, the connection terminal 28 is provided with three power supply pads 281. The multiple coils 24 are electrically connected to the three power supply pads 281 respectively, forming three full-pitch distributed lap windings 26. The three full-pitch distributed lap windings 26 are combined to form windings corresponding to three phases with electrical angle differences of 120 degrees or 240 degrees.

The connection terminal 28 is provided with an interface for connecting to an external alternating current power supply and includes three power supply pads 281 (e.g., A, B, and C). Each power supply pad 281 is connected to a set of coils 24, forming an independent full-pitch distributed lap winding 26. This design simplifies the connection to the external power supply and ensures that the full-pitch distributed lap winding 26 of each phase can be powered independently.

The flexible circuit board 20 is further provided with power supply through-holes located between the coils 24 and the power supply pads 281. The coils 24 of each full-pitch distributed lap winding 26 are electrically connected to the corresponding power supply pad 281 through the corresponding power supply through-hole. The multiple full-pitch distributed lap windings 26 are evenly distributed along the circumferential direction of the stator yoke 10, ensuring uniformity and stability of the magnetic field. The electrical angle difference between the full-pitch distributed lap windings 26 is 120 degrees or 240 degrees. A straight line part, that is, a part formed by all the second segments 232, of the wires 23 of the coils 24 of the full-pitch distributed lap winding 26 of each phase has, in each of the first conductive layer 21 and the second conductive layer 22, a width corresponding to an electrical angle of 60 degrees.

When the external alternating current power supply is connected to the three power supply pads 281 of the connection terminal 28, currents flow through the three full-pitch distributed lap windings 26 respectively, generating a rotating magnetic field. Due to the electrical angle difference of 120 degrees or 240 degrees between the three full-pitch distributed lap windings 26, the generated magnetic field forms a stable rotating magnetic field in the motor air gap. This rotating magnetic field interacts with the permanent magnets on the rotor 30, generating electromagnetic torque and driving the motor to operate. The design of the three-phase full-pitch distributed lap windings 26 allows current to flow smoothly between different conductive layers, enhancing the uniformity and strength of the magnetic field. This design is particularly suitable for high-performance three-phase alternating current motors, such as those used in robots and medical devices. The three-phase full-pitch distributed lap windings 26 can significantly improve the torque density and efficiency of the motor and reduce vibration and noise during operation.

In other embodiments, the full-pitch distributed lap windings 26 may also be in single-phase, two-phase, or other multi-phase configurations.

In an embodiment of the present application, the conductive layer is provided with a neutral-point connection hole 27. Multiple wires in the conductive layer are connected in series to form the full-pitch distributed lap winding 26 of each of the three phases. All three full-pitch distributed lap windings 26 are electrically connected to the neutral-point connection hole 27, and the full-pitch distributed lap windings 26 of the three phases are arranged in a Y-connection configuration.

The full-pitch distributed lap windings 26 of the three phases are arranged in a Y-connection configuration (star-connection configuration), that is, one end of each full-pitch distributed lap winding 26 is connected to a corresponding one of the power supply pads 281 (e.g., A, B, and C), and the other end of each full-pitch distributed lap winding 26 is connected to the same neutral point (a star point). With this connection method, the full-pitch distributed lap windings 26 have an electrical angle difference of 120 degrees between each other, forming a standard three-phase alternating current motor winding structure.

A neutral-point connection hole 27 is provided on the surface of the flexible circuit board 20 to connect common terminals of the three full-pitch distributed lap windings 26 together. The neutral-point connection hole 27 is located at a center of the flexible circuit board 20. Alternatively, the neutral-point connection hole 27 may be provided on a part of the flexible circuit board 20 close to the connection terminal 28. This neutral-point connection hole 27 is copper-plated to ensure good electrical conductivity and mechanical strength. One end of the full-pitch distributed lap winding 26 of each phase is electrically connected to the corresponding power supply pad 281 through the conductive through-holes 25, and the other end of the full-pitch distributed lap winding 26 of each phase is connected to the neutral-point connection hole 27 through the wires 23. This design ensures uniform current distribution among the full-pitch distributed lap windings 26 and forms a stable Y-connection configuration.

In an embodiment of the present application, the stator structure 1 further includes a magnetic field detection assembly 40, which includes a circuit control board 41 and a Hall sensor 42.

The Hall sensor 42 is arranged on the circuit control board 41. The circuit control board 41 is connected to a side of the flexible circuit board 20 where the connection terminal 28 is located. The flexible circuit board 20 is rolled to form a cylindrical stator winding, and the circuit control board 41 has an annular shape. After the flexible circuit board 20 is rolled to form the cylindrical stator winding, the circuit control board 41 is placed over the opening of the stator winding like a cap. Positioning grooves are provided on an outer periphery of the circuit control board 41. Positioning teeth are provided at the opening of the stator winding. The positioning teeth are limited within the positioning grooves. The Hall sensor 42 is configured to detect the magnetic field of the rotor 30 during motor operation, thereby detecting an angle of the rotor 30.

In an embodiment, the circuit control board 41 is also flexible, so as to easily fold the circuit control board 41 and place it over the opening of the stator winding. The circuit control board 41 is provided on the side of the flexible circuit board 20 close to the connection terminal 28 to facilitate the electrical connection of the circuit control board 41 and the external power supply through the connection terminal 28. In addition to pins for connecting to a positive terminal of the power supply, connecting to the ground, and signal output, the Hall sensor 42 is also provided with pins for control signals and rotational speed signals. Therefore, the Hall sensor 42 requires multiple external wire connections. By designing the circuit control board 41 to be flexible, it can be integrated with the flexible circuit board 20 during processing, allowing the Hall sensor 42 to be electrically connected to an external circuit through the connection terminal 28. This greatly improves the space utilization of the motor, reduces the structural volume, and enhances wiring convenience.

Multiple Hall sensors 42 are provided and spaced along the circumferential direction of the circuit control board 41 to improve the detection accuracy of the magnetic field detection component 40 for the magnetic field at different positions of the rotor 30. Multiple positioning grooves are provided on the outer periphery of the annular circuit control board 41. Multiple positioning teeth protrude from a side of the flexible circuit board 20. The multiple positioning teeth and the circuit control board 41 are located on the same side of the flexible circuit board 20. When the circuit control board 41 is placed over the opening of the stator winding, each positioning tooth fits into the respective positioning groove of the circuit control board 41, enabling the circuit control board 41 to be accurately mounted on the stator winding, thereby improving the accuracy and stability of the Hall sensors 42 in detecting the magnetic field of the rotor 30 during motor operation.

According to the stator winding described above, the three-phase system is arranged in a Y-connection configuration, but it may be alternatively arranged in a delta-connection configuration (FIG. 17 shows the delta-connection configuration of the stator winding). The described full-pitch distributed lap winding 26 has a single pole pair. Alternatively, it may have other number of pole pairs. The number of turns of the full-pitch distributed lap winding 26 can exceed two turns partially or entirely to increase the number of turns of the full-pitch distributed lap winding 26. The number of the conductive layers in the flexible circuit board 20 may be more than two. Similarly, the full-pitch distributed lap windings 26 may alternatively be in single-phase, two-phase, or other multi-phase configurations.

An alternating current motor is further provided according to the present application, which includes a rotor and a stator structure. The specific structure of the stator structure refers to the above embodiments. Since the alternating current motor may adopt all the technical solutions of all the embodiments of the above stator structure, it may have at least all the beneficial effects brought by the technical solutions of the above embodiments, which will not be repeated here.

The rotor is rotatably arranged within the cavity, and the flexible circuit board is arranged around an outer periphery of the rotor. The rotor is arranged within the cavity formed inside the stator yoke and is rotatable freely. The rotor may be a permanent magnet rotor or an induction rotor, which specifically depends on the application requirements.

The flexible circuit board is arranged around the outer periphery of the rotor, enabling the magnetic field generated by the stator winding to act effectively on the rotor. This design not only simplifies the mounting process but also reduces the structural volume occupied by the stator winding and improves the convenience of processing and assembly.

Only exemplary embodiments of the present application are described above, and they are not intended to limit the scope of the present application. Any equivalent structural transformation made based on the description and accompanying drawings of the present application or direct/indirect application in other related technical fields without departing from the concept of the present application shall fall within the protection scope of the present application.

## Claims

1. A stator structure, comprising:
a stator yoke, wherein a cavity is formed inside the stator yoke and runs through both ends of the stator yoke; and
a flexible circuit board, which is rolled and arranged flush against a cavity wall of the cavity, wherein
the flexible circuit board comprises at least two conductive layers, a plurality of wires are provided in each conductive layer, the wires in one conductive layer are electrically connected to the wires in another conductive layer to form a plurality of coils, and the plurality of coils are spaced apart along a circumferential direction of the stator yoke and are electrically connected to a connection terminal of the flexible circuit board.

2. The stator structure according to claim 1, wherein
the plurality of coils are connected in series to form a full-pitch distributed lap winding;
the flexible circuit board comprises a first conductive layer and a second conductive layer, and a plurality of conductive through-holes are formed in each of the first conductive layer and the second conductive layer and located close to edges thereof;
one wire in the first conductive layer is electrically connected to one wire in the second conductive layer through one conductive through-hole located close to one edge of the flexible circuit board, the one wire in the second conductive layer is electrically connected to another wire in the first conductive layer through another conductive through-hole located close to another edge of the flexible circuit board, and the another wire in the first conductive layer is electrically connected to another wire in the second conductive layer through yet another conductive through-hole located close to the one edge of the flexible circuit board; and
the plurality of wires in the first conductive layer are connected to the plurality of wires in the second conductive layer in an alternating sequence, forming the full-pitch distributed lap winding of each phase.

3. The stator structure according to claim 2, wherein
each wire comprises at least a first segment, a second segment, and a third segment connected in the listed sequence, the second segment is parallel to an axial direction of the stator yoke, and the first segment and the third segment are inclined in different directions relative to the second segment; and
the plurality of wires in each conductive layer are sequentially arranged and spaced apart along the circumferential direction of the stator yoke.

4. The stator structure according to claim 3, wherein
a projection of at least one first segment in the first conductive layer in a direction perpendicular to a surface of the flexible circuit board intersects a projection of at least one first segment in the second conductive layer in the same direction; and
a projection of at least one third segment in the first conductive layer in the direction perpendicular to the surface of the flexible circuit board intersects a projection of at least one third segment in the second conductive layer in the same direction.

5. The stator structure according to claim 4, wherein
projections of a plurality of second segments in the first conductive layer and a plurality of second segments in the second conductive layer in the direction perpendicular to the surface of the flexible circuit board are evenly spaced; and
two ends of the flexible circuit board abut against each other, and the flexible circuit board is rolled and arranged flush against an inner wall of the stator yoke.

6. The stator structure according to claim 4, wherein
part of projections of a plurality of second segments in the first conductive layer in the direction perpendicular to the surface of the flexible circuit board overlap with part of projections of a plurality of second segments in the second conductive layer in the same direction, or are spaced apart from part of projections of a plurality of second segments in the second conductive layer in the same direction by a small line spacing; and
twos ends of the flexible circuit board partially overlap with each other, and the flexible circuit board is rolled and arranged flush against an inner wall of the stator yoke.

7. The stator structure according to any one of claims 3 to 6, wherein a line width of the second segment is greater than a line width of the first segment and a line width of the third segment.

8. The stator structure according to any one of claims 3 to 6, wherein
the flexible circuit board is polygonal in shape, and the wires are parallel to sides of the flexible circuit board adjacent to the wires; or,
the flexible circuit board is rectangular in shape, and the wires form right angles close to corners of the flexible circuit board to fully utilize space of the flexible circuit board that is rectangular in shape.

9. The stator structure according to any one of claims 1 to 6, wherein the conductive layers are provided with a neutral-point connection hole, a plurality of the wires in the conductive layers are connected in series to form a full-pitch distributed lap winding of each of three phases, the full-pitch distributed lap windings of the three phases are all electrically connected to the neutral-point connection hole, and the full-pitch distributed lap windings of the three phases are arranged in a Y-connection configuration.

10. An alternating current motor, comprising:
a rotor; and
the stator structure according to any one of claims 1 to 9, wherein
the rotor is rotatably disposed within the cavity, and the flexible circuit board is arranged around an outer periphery of the rotor.
